# EUROPEAN PATENT APPLICATION

(11) **EP 4 512 988 A1**
(43) Date of publication of application: **26.02.2025**
(21) Application number: 23871055.2
(22) Date of filing: 28.09.2023
(51) Int. Cl.: E05F 15/75

(54) **METHOD AND APPARATUS FOR CONTROLLING OPENING/CLOSING OF VEHICLE DOOR, VEHICLE, AND COMPUTER STORAGE MEDIUM**

(30) Priority: 30.09.2022 CN 202211216842
(71) Applicant: ZHEJIANG ZEEKR INTELLIGENT TECHNOLOGY CO., LTD., 315000 Ningbo Zhejiang (CN); Zhejiang Geely Holding Group Co., Ltd., Hangzhou, Zhejiang 310000 (CN)
(72) Inventor: GAO, Wenqing, Ningbo, Zhejiang 315000 (CN); YAN, Tingbin, Ningbo, Zhejiang 315000 (CN); LI, Guolin, Ningbo, Zhejiang 315000 (CN); CAI, Xinhang, Ningbo, Zhejiang 315000 (CN); WANG, Yong, Ningbo, Zhejiang 315000 (CN); LI, Lianlei, Ningbo, Zhejiang 315000 (CN); CHEN, Hongqiang, Ningbo, Zhejiang 315000 (CN); XU, Yun, Ningbo, Zhejiang 315000 (CN)
(74) Representative: Osterhoff, Utz
(86) International application number: PCT/CN2023/122751
(87) International publication number: WO 2024/067831

(57) **Abstract**

Disclosed are a method and a device for controlling opening and closing of a vehicle door, a vehicle, and a computer readable storage medium. On the basis of a vehicle provided with a capacitive sensing area having a plurality of capacitive sensing points, a touch sliding operation executed by a vehicle user is acquired by means of the capacitive sensing area; according to trigger state information of the touch sliding operation for the plurality of capacitive sensing points, it is determined whether the touch sliding operation is an accidental touch operation; and finally, in response to that the touch sliding operation is not the accidental touch operation, according to a triggering sequence of the touch sliding operation for the plurality of capacitive sensing points, the vehicle door is immediately controlled to be opened or closed.

## Description

The present application claims priority to Chinese patent application No. 202211216842.1, filed on September 30, 2022. The disclosures of the above-mentioned applications are incorporated herein by reference in their entireties.

### TECHNICAL FIELD

The present application relates to the technical field of vehicle, and in particular to a method and a device for controlling opening and closing of a vehicle door, a vehicle and a computer readable storage medium.

### BACKGROUND

Nowadays, the application of the vehicle door with electric opening and closing has received more and more attention in the industry. However, the existing method for controlling opening and closing of the vehicle door by collecting the user's touch and click actions through capacitive sensors is very prone to the phenomenon of false triggering of the vehicle door to be opened and closed due to rainfall; especially when the rainfall is heavy, the false triggering of the vehicle door to be opened and closed is more frequent.

In summary, in the related art, a capacitive sensor is configured for the user to touch and click to electrically open and close the vehicle door, but there is a technical problem that the vehicle door may be triggered by mistake.

### SUMMARY

The main purpose of the present application is to provide a method and a device for controlling opening and closing of a vehicle door, a vehicle and a computer readable storage medium, aiming to control the electric opening and closing of the vehicle door by a vehicle door triggering method combining multi-point capacitance with algorithm timing, thereby effectively reducing the probability of capacitor false triggering the vehicle door to be opened and closed, so as to solve the technical problem that the traditional electric opening and closing of the vehicle door method is easily triggered by error.

In order to achieve the above object, the present application provides a method for controlling opening and closing of a vehicle door; the method for controlling opening and closing of the vehicle door is applied to a vehicle equipped with a capacitive sensing area, and the capacitive sensing area includes a plurality of capacitive sensing points;
the method for controlling opening and closing of the vehicle door includes:
collecting a touch sliding operation performed by a vehicle user through the capacitive sensing area;
determining whether the touch sliding operation is an accidental touch operation according to trigger state information of the touch sliding operation on the plurality of capacitive sensing points; and
in response to that the touch sliding operation is not the accidental touch operation, controlling opening or closing the vehicle door according to a triggering
sequence of the touch sliding operation for the plurality of capacitive sensing points.

In an embodiment, before the determining whether the touch sliding operation is the accidental touch operation according to the trigger state information of the touch sliding operation on the plurality of capacitive sensing points, the method further includes:
acquiring a touch dwell time of the touch sliding operation on a first sensing point among the plurality of capacitive sensing points; the first sensing point is a first capacitive sensing point arranged in a direction corresponding to an opening and closing direction of the vehicle door among the plurality of capacitive sensing points;
acquiring a touch sliding speed of the touch sliding operation on two adjacent sensing points among the plurality of capacitive sensing points;
acquiring a touch sliding time for the touch sliding operation to complete touching the plurality of capacitive sensing points; and
determining the touch dwell time, the touch sliding speed and the touch sliding time as the trigger state information of the touch sliding operation for the plurality of capacitive sensing points.

In an embodiment, the determining whether the touch sliding operation is the accidental touch operation according to the trigger state information of the touch sliding operation on the plurality of capacitive sensing points includes:
detecting whether the touch dwell time is greater than a preset dwell time threshold, detecting whether the touch sliding speed is greater than a preset speed threshold, and detecting whether the touch sliding time belongs to a preset sliding completion time range; and
in response to the touch dwell time being greater than the dwell time threshold, the touch sliding speed being greater than the speed threshold, and the touch sliding time belonging to the sliding completion time range, determining that the touch sliding operation is not the accidental touch operation.

In an embodiment, a number of the plurality of capacitive sensing points is greater than or equal to three;
the controlling opening or closing the vehicle door according to the triggering sequence of the touch sliding operation for the plurality of capacitive sensing points includes:
determining a triggering sequence of the touch sliding operation on at least three capacitive sensing points among the plurality of capacitive sensing points; and
in response to that the triggering sequence corresponds to the opening direction of the vehicle door, controlling the vehicle door to be opened; or, in response to that the triggering sequence corresponds to the closing direction of the vehicle door, controlling the vehicle door to be closed.

In an embodiment, after the determining the triggering sequence of the touch sliding operation on at least three capacitive sensing points among the plurality of capacitive sensing points, the method further includes:
acquiring a real-time opening and closing state of the vehicle door;
controlling the vehicle door to be opened or closed according to the real-time opening and closing state and a corresponding relationship between the triggering sequence and the opening and closing direction of the vehicle door; or
according to the real-time opening and closing state and the corresponding relationship between the triggering sequence and the opening and closing direction of the vehicle door, outputting a preset opening and closing instruction prompt of the vehicle door to control the vehicle door to be opened or closed based on a confirmation operation of the opening and closing instruction prompt of the vehicle door.

In an embodiment, the method further includes:
collecting a password configuration operation of the vehicle door performed by a vehicle user through the capacitive sensing area;
configuring the triggering sequence of the password configuration operation of the vehicle door for the plurality of capacitive sensing points as a control password of the vehicle door; and
in response to that the triggering sequence of the touch sliding operation collected by the capacitive sensing area for the plurality of capacitive sensing points is consistent with the control password of the vehicle door, controlling the vehicle door to be opened or closed.

In an embodiment, the vehicle is further provided with a protection electrode area, and the protection electrode area is provided at a peripheral position of the capacitive sensing area; the method further includes:
collecting a protection capacitance value around the capacitive sensing area through the protection electrode area, and detecting whether the protection capacitance value exceeds a preset protection capacitance threshold; and
in response to that the protection capacitance value exceeds the protection capacitance threshold, shielding a induction signal collected by the capacitive sensing area.
In order to achieve the above object, the present application also provides a device for controlling opening and closing of a vehicle door; the device for controlling opening and closing of the vehicle door is applied to a vehicle equipped with a capacitive sensing area, and the capacitive sensing area includes a plurality of capacitive sensing points;
the device for controlling opening and closing of the vehicle door includes:
   a collection module, configured for collecting a touch sliding operation performed by a vehicle user through the capacitive sensing area;
   an accidental touch determination module, configured to determine whether the touch sliding operation is an accidental touch operation according to trigger state information of the touch sliding operation on the plurality of capacitive sensing points; and
   a control module, configured to control opening or closing of the vehicle door according to a triggering sequence of the touch sliding operation for the plurality of the capacitive sensing points in response to that the touch sliding operation is not the accidental touch operation.

In order to achieve the above object, the present application also provides a vehicle, including:
a memory;
a processor; and
a program stored in the memory for implementing a method for controlling opening and closing of a vehicle door;
the memory is configured to store the program for implementing the method for controlling opening and closing of the vehicle door; and
the processor is configured to execute the program for implementing the method for controlling opening and closing of the vehicle door, so as to implement the steps of the method for controlling opening and closing of the vehicle door.

In order to achieve the above object, the present application also provides a computer readable storage medium; a program for implementing a method for controlling opening and closing of a vehicle door is stored on the computer readable storage medium, and the program for implementing the method for controlling opening and closing of the vehicle door is executed by a processor to implement the steps of the method for controlling opening and closing of the vehicle door.

The present application provides a method and a device for controlling opening and closing of a vehicle door, a vehicle and a computer readable storage medium. On the basis of a vehicle provided with a capacitive sensing area having a plurality of capacitive sensing points, a touch sliding operation executed by a vehicle user is acquired by means of the capacitive sensing area; according to trigger state information of the touch sliding operation for the plurality of capacitive sensing points, it is determined whether the touch sliding operation is an accidental touch operation; and finally, in response to that the touch sliding operation is not the accidental touch operation, according to a triggering sequence of the touch sliding operation for the plurality of capacitive sensing points, the vehicle door is immediately controlled to be opened or closed.

In this way, the present application forms a capacitive sensing area by combining multiple capacitive sensing points, thereby collecting the touch sliding operation of the vehicle user to control the vehicle door to be opened and closed based on the capacitive sensing area, and judging the collected touch sliding operation in combination with the algorithm to determine whether the touch sliding operation is a false trigger. That is, the present application realizes the control of the electric opening and closing of the vehicle door through the vehicle door triggering method of multi-point capacitance combined with algorithm timing, which can effectively reduce the probability of capacitor false triggering the vehicle door to be opened and closed, thereby solving the technical problem that the traditional electric opening and closing of the vehicle door method is easily falsely triggered.

### BRIEF DESCRIPTION OF THE DRAWINGS

The accompanying drawings, which are incorporated in and constitute a part of this specification, illustrate embodiments consistent with the present application, and together with the description, serve to explain the principles of the present application.

In order to more clearly illustrate the technical solutions in the embodiments of the present application or the related technologies, the drawings required for use in the embodiments or the related technical descriptions are briefly introduced below. Obviously, for those skilled in the art, other drawings can be obtained based on these drawings without paying any creative labor.
FIG. 1 is a flow chart of a method for controlling opening and closing of a vehicle door according to an embodiment of the present invention.
FIG. 2 is a structural schematic diagram of a capacitive sensing area and a protection electrode area of the method for controlling opening and closing of the vehicle door according to an embodiment of the present invention.
FIG. 3 is a structural schematic diagram of the functional modules of a device for controlling opening and closing of the vehicle door according to an embodiment of the present invention.
FIG. 4 is a structural schematic diagram of a hardware operating environment device of the vehicle according to an embodiment of the present invention.

The purpose, features and advantages of the present application will be further described in conjunction with the embodiments and with reference to the accompanying drawings.

### DETAILED DESCRIPTION OF THE EMBODIMENTS

It should be understood that the specific embodiments described herein are only configured to explain the present application and are not configured to limit the present application.

It should be noted that the application of the electric opening and closing of the vehicle door has received more and more attention in the industry. However, the existing method for controlling the vehicle door to be opened and closed by collecting the user's touch and click actions through capacitive sensors is very prone to the phenomenon of false triggering of the vehicle door to be opened and closed due to rainfall; especially when the rainfall is heavy, the false triggering of the vehicle door to be opened and closed is more frequent.

In summary, the existing method of using a capacitive sensor for the user to touch and click to electrically open and close the vehicle door has a technical problem of the vehicle door to be opened and closed triggered by mistake.

Based on the above phenomenon, an embodiment of the present application provides a method for controlling opening and closing of a vehicle door, by configuring a vehicle provided with a capacitive sensing area having a plurality of capacitive sensing points, a touch sliding operation executed by a vehicle user is acquired by means of the capacitive sensing area; according to trigger state information of the touch sliding operation for the plurality of capacitive sensing points, it is determined whether the touch sliding operation is an accidental touch operation; and finally, in response to that the touch sliding operation is not the accidental touch operation, according to a triggering sequence of the touch sliding operation for the plurality of capacitive sensing points, the vehicle door is immediately controlled to be opened or closed.

In an embodiment of the method for controlling opening and closing of the vehicle door of the present application, the present application forms a capacitive sensing area by combining multiple capacitive sensing points, thereby collecting the touch sliding operation of the vehicle user to control the vehicle door to be opened and closed based on the capacitive sensing area, and judging the collected touch sliding operation in combination with an algorithm to determine whether the touch sliding operation is an erroneous trigger. In this way, the present application realizes the control of the electric opening and closing of the vehicle door by combining the vehicle door to be opened and closed triggering method of multi-point capacitance combined with algorithm timing, which can effectively reduce the probability of the capacitor erroneously triggering the vehicle door to be opened and closed, thereby solving the technical problem that the traditional electric opening and closing of the vehicle door method is easily triggered by error.

Based on the overall concept of the method for controlling opening and closing of the vehicle door of the present application, a first embodiment of the method for controlling opening and closing of the vehicle door of the present application is proposed.

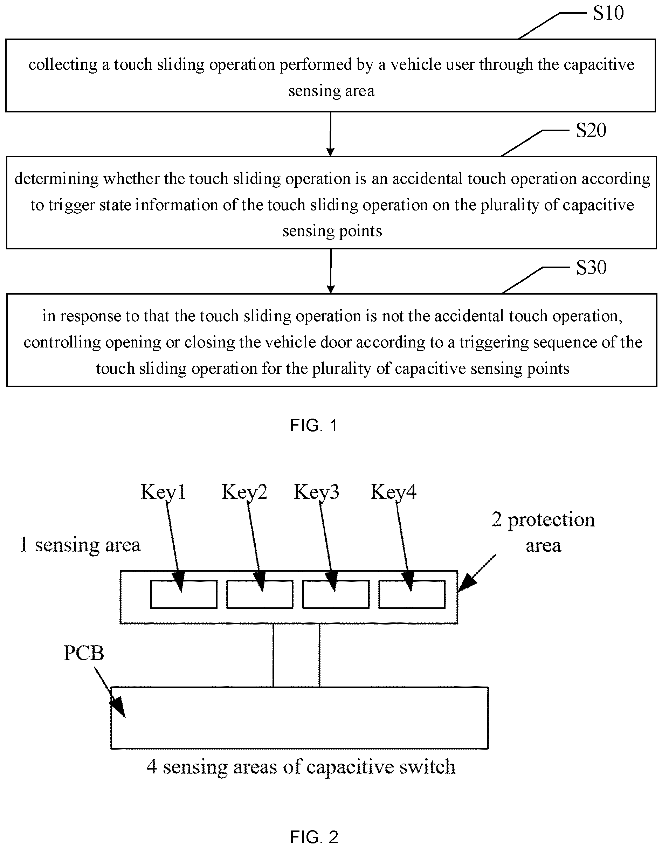

Please referring to FIG. 1, which is a flowchart of a first embodiment of a method for controlling opening and closing of the vehicle door of the present application. It should be noted that although a logical sequence is shown in the flowchart, in some cases, the steps shown or described may be performed in a different order than that shown here.

In addition, in this embodiment, the execution subject of the method for controlling opening and closing of the vehicle door of the present application can be the vehicle itself. For the convenience of explanation and reading understanding, the following text uses the vehicle as the execution subject to explain the first embodiment of the method for controlling opening and closing of the vehicle door of the present application.

As shown in FIG. 1, in a first embodiment of the method for controlling opening and closing of the vehicle door of the present application, the method for controlling opening and closing of the vehicle door of the present application specifically includes the following steps:
Step S10, collecting a touch sliding operation performed by a vehicle user through the capacitive sensing area;
In this embodiment, the vehicle configures a capacitive sensing area formed by a combination of multiple capacitive sensing points at a position on the outside and/or inside of the vehicle door that is suitable for the vehicle driver or passenger to operate. In this way, the vehicle can collect vehicle users including the vehicle driver, passengers or other personnel through the capacitive sensing area; in order to control the opening or closing of the vehicle door by touch, the touch sliding operation is performed in the capacitive sensing area.

It should be noted that, as a feasible embodiment, the positions on the outside of the above-mentioned vehicle door suitable for the vehicle driver or passenger to operate include but are not limited to: around the vehicle windows, the edge of the vehicle door close to the B-pillar of the vehicle body, and the position of the vehicle rearview mirror.

In addition, the capacitive sensing area formed by the combination of multiple capacitive sensing points can be specifically shown as "1 sensing area" in FIG. 2, that is, multiple capacitive sensing points (key1 to key4 in the figure) are arranged horizontally in sequence to form the entire capacitive sensing area. It should be understood that based on the different design needs of actual applications, multiple capacitive sensing points can of course be arranged in other combinations different from those listed here to form a capacitive sensing area, such as, multiple capacitive sensing points are arranged vertically in sequence, multiple capacitive sensing points are arranged side by side horizontally or vertically, and multiple capacitive sensing points are arranged in regular lines (such as arcs) or irregular lines (such as wavy lines) in sequence, etc. That is, the method for controlling opening and closing of the vehicle door of the present application is not limited to the position combination relationship of multiple capacitive sensing points, as long as a complete capacitive sensing area is formed by combining multiple capacitive sensing points to collect the touch sliding operation performed by the vehicle user.

Step S20, determining whether the touch sliding operation is an accidental touch operation according to the trigger state information of the touch sliding operation on the plurality of capacitive sensing points;
In this embodiment, while the vehicle is collecting the touch sliding operation performed by the vehicle user through the above-mentioned capacitive sensing area, the vehicle also obtains the trigger state information of the touch sliding operation for multiple capacitive sensing points based on one or more capacitive sensing points in the capacitive sensing area. Therefore, the vehicle can determine whether the currently collected touch sliding operation is an accidental touch operation performed by the vehicle user or other objects in the capacitive sensing area based on the trigger state information in combination with the algorithm.

In an embodiment, the trigger state information of the touch sliding operation for multiple capacitive sensing points includes but is not limited to: touch dwell time, touch sliding speed and touch sliding time. Based on this, before the above step S20, the method for controlling opening and closing of the vehicle door of the present application may also include:
Step a, acquiring the touch dwell time of the touch sliding operation on a first sensing point among the plurality of capacitive sensing points; the first sensing point is the first capacitive sensing point arranged in a direction corresponding to the vehicle door to be opened and closed of the plurality of capacitive sensing points;
In this embodiment, when the vehicle passes through the entire capacitive sensing area - 1 sensing area as shown in FIG. 2, and collects the touch sliding operation performed by the vehicle user, it first uses the first sensing point in the capacitive sensing area - key1 or key4 to obtain the touch dwell time when the vehicle user starts to perform the touch sliding operation and stays at the first sensing point to perform the touch operation on the first sensing point.

It should be noted that, as shown in FIG. 2, if the vehicle is pre-configured with multiple capacitive sensing points in the sensing area, the arrangement order of the points from key1 to key4 corresponds to the opening direction of the vehicle door, and the arrangement order from key4 to key1 corresponds to the closing direction of the vehicle door. Then, when the vehicle user performs a touch sliding operation in the order from key1 to key4 to control the opening of the vehicle door, the above-mentioned first sensing point is key1; or, when the vehicle user performs a touch sliding operation in the order from key4 to key1 to control the opening of the vehicle door, the above-mentioned first sensing point is key4.
Step b, acquiring the touch sliding speed of the touch sliding operation on two adjacent sensing points among the plurality of capacitive sensing points;
In this embodiment, when the vehicle passes through the entire capacitive sensing area as shown in FIG. 2 - 1 sensing area, and collects the touch sliding operation performed by the vehicle user, it also obtains the touch sliding operation performed by the vehicle user through two adjacent sensing points in the capacitive sensing area - key1 and key2, key2 and key3, or key3 and key4, and the touch sliding speed between the two sensing points.

Step c, acquiring the touch sliding time for the touch sliding operation to complete touching the plurality of capacitive sensing points;
In this embodiment, when the vehicle passes through the entire capacitive sensing area - 1 sensing area as shown in FIG. 2 to collect the touch sliding operation performed by the vehicle user, it also obtains the touch sliding operation performed by the vehicle user through all the sensing points in the capacitive sensing area - key1 to key4. After starting to touch key1, key2, key3 and key4 are touched in sequence to complete the touch sliding time consumed for touching all the sensing points.

Step d, determining the touch dwell time, the touch sliding speed and the touch sliding time as trigger state information of the touch sliding operation for the plurality of capacitive sensing points.

In this embodiment, the vehicle synchronously or asynchronously obtains the touch sliding operation performed by the vehicle user based on one or more capacitive sensing points in the above-mentioned capacitive sensing area; and after the touch dwell time of the first sensing point among the multiple capacitive sensing points, the touch sliding speed of any two adjacent capacitive sensing points among the multiple capacitive sensing points, and the touch sliding time for all the capacitive sensing points, the touch dwell time, the touch sliding speed, and the touch sliding time can be further used as trigger state information of the touch sliding operation for the multiple capacitive sensing points.

In an embodiment, the above step S20, determining whether the touch sliding operation is an accidental touch operation according to the trigger state information of the touch sliding operation on the plurality of capacitive sensing points, may include:
Step S201, detecting whether the touch dwell time is greater than a preset dwell time threshold, detecting whether the touch sliding speed is greater than a preset speed threshold, and detecting whether the touch sliding time belongs to a preset sliding completion time range;
In this embodiment, after the vehicle obtains the trigger state information of the touch sliding operation for multiple capacitive sensing points based on one or more capacitive sensing points in the above-mentioned capacitive sensing area, it immediately combines the algorithm strategy to detect each trigger state information; that is, first detecting whether the touch dwell time is greater than the preset residence time threshold, then detecting whether the touch sliding speed is greater than the preset speed threshold, and finally, detecting whether the touch sliding time falls within the preset sliding completion time range.

It should be noted that, in a feasible embodiment, in the above-mentioned algorithm strategy, the dwell time threshold can be specifically set to 200ms, and the speed threshold is set based on the distance between two adjacent capacitive sensing points: the time taken by the user to touch and slide from the previous capacitive sensing point to the next capacitive sensing point shall not be less than 10ms, and considering the possible time taken by a human hand to normally perform a complete touch sliding operation, the algorithm strategy can directly set the sliding completion time range to: 50ms to 1500ms.

Step S202, if the touch dwell time is greater than the dwell time threshold, the touch sliding speed is greater than the speed threshold, and the touch sliding time belongs to the sliding completion time range, it is determined that the touch sliding operation is not an accidental touch operation.

In this embodiment, when the vehicle detects each trigger state information in sequence, if it is detected that the touch dwell time is greater than or equal to the dwell time threshold, the touch sliding speed is greater than the speed threshold, and the touch sliding time belongs to the sliding completion time range, then the vehicle determines that the touch sliding operation currently performed by the vehicle user is not an accidental touch operation.

Exemplarily, as shown in FIG. 2, when the vehicle detects each trigger state information in sequence in combination with the above-mentioned algorithm strategy, if the touch of the first sensing point key1 or key4 corresponding to the opening and closing direction of the vehicle door stays for 200ms or more; and from the perspective of any two adjacent sensing points, the time taken to touch the previous key and then slide to the next key is higher than 10ms; and the time taken to complete the touch of all four keys is between 50ms and 1500ms (experiments show that the time taken for a human hand to normally perform the touch sliding operation on all the illustrated key1 to key4 is about 500ms); then the vehicle determines that the touch sliding operation performed by the vehicle user currently collected through the sensing area is not an accidental touch operation on the sensing area.

It should be noted that, in this embodiment, if the vehicle detects, in combination with the above-mentioned algorithm strategy, that any trigger state information does not meet the corresponding strategy conditions, such as, the touch dwell time is less than the dwell time threshold, the touch sliding speed is less than the speed threshold, and the touch sliding time does not belong to the sliding completion time range, then the vehicle determines that the touch sliding operation currently performed by the vehicle user is an incorrect touch operation.

Step S30, when it is determined that the touch sliding operation is not an accidental touch operation, the vehicle door is controlled to be opened or closed according to the triggering sequence of the touch sliding operation for the plurality of capacitive sensing points.

In this embodiment, when the vehicle determines based on the above-mentioned trigger state information combined with the algorithm that the currently collected touch sliding operation is not an accidental touch operation performed by the vehicle user or other objects in the capacitive sensing area, the vehicle controls the opening or closing of the vehicle door according to the triggering sequence of the touch sliding operation touching multiple capacitive sensing points in sequence.

In an embodiment, the number of the capacitive sensing points in the capacitive sensing area is greater than or equal to three. Based on this, the above step S40 may include:
Step S301, determining a triggering sequence of the touch sliding operation on at least three capacitive sensing points among the plurality of capacitive sensing points;
Step S302, if the triggering sequence corresponds to the opening direction of the vehicle door, the vehicle door is controlled to be opened; or, if the triggering sequence corresponds to the closing direction of the vehicle door, the vehicle door is controlled to be closed.

In this embodiment, when the vehicle controls the vehicle door to open and close according to the touch sliding operation performed by the vehicle user, the vehicle first determines the triggering sequence of the touch sliding operation for the three capacitive sensing points based on at least three consecutive capacitive sensing points in the capacitive sensing area where the touch sliding operation is collected. After that, the vehicle further corresponds the triggering sequence to the preset opening and closing direction of the vehicle door, so that when the triggering sequence corresponds to the preset opening direction, the vehicle immediately controls the vehicle door to open, and when the triggering sequence corresponds to the preset closing direction, the vehicle immediately controls the vehicle door to close.

Exemplarily, as shown in FIG. 2, it is assumed that the triggering sequence from key1 to key4 in the vehicle's pre-set sensing area corresponds to the opening direction of the vehicle door, and the triggering sequence from key4 to key1 corresponds to the closing direction of the vehicle door. Then in this embodiment, if the vehicle determines that the triggering sequence of the touch sliding operation currently performed by the vehicle user for the three keys among all the capacitive sensing points is key1, key2 to key3 based on key1 to key4, then the vehicle determines that the triggering sequence of the touch sliding operation at this time corresponds to the opening direction of the vehicle door. Similarly, if the vehicle determines that the triggering sequence of the touch sliding operation currently performed by the vehicle user for the three keys among all the capacitive sensing points is key4, key3 to key2 based on key1 to key4, then the vehicle determines that the triggering sequence of the touch sliding operation at this time corresponds to the closing direction of the vehicle door.

It should be noted that, in a feasible embodiment, the vehicle can control the vehicle door to be opened or closed through the drive motor configured corresponding to the vehicle door, thereby realizing electric opening and closing of the vehicle door.

In an embodiment of the present application, the method for controlling opening and closing of the vehicle door provided by the present application is that the vehicle configures a capacitive sensing area formed by a combination of multiple capacitive sensing points at a position on the outside and/or inside of the vehicle door that is suitable for the vehicle driver or passenger to operate. **In** this way, the vehicle can collect the touch sliding operations performed in the capacitive sensing area by vehicle users including the vehicle driver, passengers or other personnel in order to control the opening or closing of the vehicle door by touch through the capacitive sensing area.

While the vehicle is collecting the touch sliding operation performed by the vehicle user through the above-mentioned capacitive sensing area, the vehicle also obtains trigger state information of the touch sliding operation for multiple capacitive sensing points based on one or more capacitive sensing points in the capacitive sensing area. Therefore, the vehicle can determine whether the currently collected touch sliding operation is an accidental touch operation performed by the vehicle user or other objects in the capacitive sensing area based on the trigger state information combined with the algorithm.

Furthermore, when the vehicle determines, based on the above-mentioned trigger state information and the algorithm, that the currently collected touch sliding operation is not an accidental touch operation performed by the vehicle user or other objects in the capacitive sensing area, the vehicle controls the opening or closing of the vehicle door according to the triggering sequence of the touch sliding operation touching multiple capacitive sensing points in sequence.

In this way, the present application forms a capacitive sensing area by combining multiple capacitive sensing points, thereby collecting the touch sliding operation of the vehicle user to control the vehicle door to be opened and closed based on the capacitive sensing area, and judging the collected touch sliding operation in combination with the algorithm to determine whether the touch sliding operation is a false trigger. That is, the present application realizes the control of the electric opening and closing of the vehicle door through the vehicle door triggering method of multi-point capacitance combined with algorithm timing, which can effectively reduce the probability of capacitor false triggering the vehicle door to be opened and closed, thereby solving the technical problem that the traditional electric opening and closing of the vehicle door method is easily falsely triggered.

Furthermore, based on the first embodiment of the method for controlling opening and closing of the vehicle door of the present application, a second embodiment of the method for controlling opening and closing of the vehicle door of the present application is proposed.

In this embodiment, after determining the triggering sequence of the touch sliding operation on at least three capacitive sensing points among the plurality of capacitive sensing points in the above step S301, the method for controlling opening and closing of the vehicle door of the present application may further include:
Step S303, acquiring the real-time opening and closing state of the vehicle door;
In this embodiment, when the vehicle collects the touch sliding operation performed by the vehicle user through the above-mentioned capacitive sensing area, the vehicle also synchronously or asynchronously obtains the real-time opening and closing state of the vehicle door.

For example, the vehicle may obtain a bus signal transmitted by a door controller through a controller area network (CAN) to obtain the real-time opening and closing state of one or more vehicle doors.

Step S304, controlling the vehicle door to be opened or closed according to the real-time opening and closing state and the corresponding relationship between the triggering sequence and the opening and closing direction of the vehicle door;

In this embodiment, after the vehicle determines that the operation is not an accidental touch operation through the above-mentioned touch sliding operation, and determines the triggering sequence of the operation for at least three of the multiple capacitive sensing points according to the touch sliding operation, and the corresponding relationship between the triggering sequence and the opening direction of the vehicle door is that the triggering sequence corresponds to the opening direction of the vehicle door or the triggering sequence corresponds to the closing direction of the vehicle door, the vehicle further controls the vehicle door to be opened or closed based on the real-time opening and closing state of the vehicle door and the corresponding relationship. That is, if the current real-time opening and closing state of the vehicle door is closed, and the triggering sequence of the touch sliding operation for at least three consecutive capacitive sensing points determined by the vehicle corresponds to the opening direction of the vehicle door, the vehicle immediately controls the vehicle door to be opened; or, if the current real-time opening and closing state of the vehicle door is opened, and the triggering sequence of the touch sliding operation for at least three consecutive capacitive sensing points determined by the vehicle corresponds to the closing direction of the vehicle door, the vehicle immediately controls the vehicle door to be closed.

Step S305, according to the real-time opening and closing state and the corresponding relationship between the triggering sequence and the opening and closing direction of the vehicle door, outputting a preset opening and closing instruction prompt of the vehicle door to control the vehicle door to be opened or closed based on the confirmation operation of the opening and closing instruction prompt of the vehicle door.

**In** this embodiment, if the current real-time opening and closing state of the vehicle door is closed, but the touch sliding operation determined by the vehicle corresponds to the closing direction of the vehicle door for the triggering sequence of at least three consecutive capacitive sensing points, the vehicle will immediately output a pre-set opening and closing instruction prompt of the vehicle door of "the current vehicle door is closed, please confirm whether to open the vehicle door" to the vehicle user through a speaker configured on the outside and/or inside of the vehicle. **In** this way, the vehicle user can feedback the confirmation operation based on the prompt through voice or by re-performing a new touch sliding operation in the capacitive sensing area, so that the vehicle can control the opening of the vehicle door based on the confirmation operation.

Similarly, if the current real-time opening and closing state of the vehicle door is open, but the touch sliding operation determined by the vehicle corresponds to the opening direction of the vehicle door for the triggering sequence of at least three consecutive capacitive sensing points, the vehicle will immediately output a pre-set opening and closing instruction prompt of the vehicle door of "the current vehicle door is open, please confirm whether to close the vehicle door" to the vehicle user through a speaker configured on the outside and/or inside of the vehicle. In this way, the vehicle user can feedback the confirmation operation based on the prompt through voice or by re-performing a new touch sliding operation in the capacitive sensing area, so that the vehicle can control the closing of the vehicle door based on the confirmation operation.

In an embodiment, the vehicle can also provide a vehicle door password setting function to the vehicle user through multiple capacitive sensing points in the capacitive sensing area. Based on this, the method for controlling opening and closing of the vehicle door of the present application can also include:
Step A, collecting the password configuration operation of the vehicle door performed by the vehicle user through the capacitive sensing area;
Step B, configuring the triggering sequence of the password configuration operation of the vehicle door for the plurality of capacitive sensing points as a vehicle door control password;
Step C, when the triggering sequence of the touch sliding operation collected by the capacitive sensing area for the plurality of the capacitive sensing points is consistent with the control password of the vehicle door, controlling the vehicle door to be opened or closed.

In this embodiment, before the vehicle collects the touch sliding operation performed by the vehicle user through the capacitive sensing area to determine whether the operation is an accidental touch operation, and the vehicle door is controlled to open and close when the judgment result is no, the vehicle can also collect the vehicle user's need to configure the vehicle door password through the capacitive sensing area, and perform the password configuration operation of the vehicle door by touching and/or touching and sliding each capacitive sensing point in sequence in the capacitive sensing area. Therefore, the vehicle can directly configure, the triggering sequence of the password configuration operation of the vehicle door for sequentially touching and/or touching and sliding on multiple capacitive sensing points, as the control password of the vehicle door set by the vehicle user.

In this way, when the vehicle user needs to control the opening and closing of the vehicle door directly through the control password of the vehicle door set by himself in the future when approaching the vehicle without carrying the vehicle key, he can perform the touch sliding operation according to the control password of the vehicle door based on the capacitive sensing area configured for the vehicle. After the vehicle collects the touch sliding operation performed by the user based on the capacitive sensing area, it analyzes and determines whether the triggering sequence of the touch sliding operation on multiple capacitive sensing points in the capacitive sensing area is consistent with the control password of the vehicle door set by the vehicle user before. When it is determined that they are consistent, a prompt of successful unlocking is output to the user, and the vehicle door is opened directly; or after further waiting for the vehicle user to perform a new touch sliding operation, the vehicle door is controlled to be opened according to the process described in steps S10 to S30 above.

In an embodiment of the present application, the method for controlling opening and closing of the vehicle door of the present application is that when the vehicle collects the touch sliding operation performed by the vehicle user through the above-mentioned capacitive sensing area, it also synchronously or asynchronously obtains the real-time opening and closing state of the vehicle door. Therefore, after the vehicle determines that the operation is not an accidental touch operation through the above-mentioned touch sliding operation, and determines the triggering sequence of the operation for at least three capacitive sensing points among the multiple capacitive sensing points according to the touch sliding operation, and the corresponding relationship between the triggering sequence and the opening and closing direction of the vehicle door is that the triggering sequence corresponds to the opening direction of the vehicle door or the triggering sequence corresponds to the closing direction of the vehicle door, based on the real-time opening and closing state of the vehicle door and the corresponding relationship, the vehicle door is controlled to be opened or closed. That is, if the real-time opening and closing state of the current vehicle door is closed, and the triggering sequence of the touch sliding operation for at least three consecutive capacitive sensing points determined by the vehicle corresponds to the opening direction of the vehicle door, the vehicle immediately controls the vehicle door to be opened; or, if the real-time opening and closing state of the current vehicle door is open, and the triggering sequence of the touch sliding operation for at least three consecutive capacitive sensing points determined by the vehicle corresponds to the closing direction of the vehicle door, the vehicle immediately controls the vehicle door to be closed. In this way, the intelligence of controlling opening and closing of the vehicle door is further improved, and the user experience is better.

In addition, the method for controlling opening and closing of the vehicle door of the present application also provides the vehicle user with a password setting function of the vehicle door through multiple capacitive sensing points in the capacitive sensing area, so that the vehicle user can independently set a functional password for controlling the vehicle door based on the capacitive sensing area; and then, when approaching the vehicle without carrying the vehicle key, the vehicle user can directly control the opening and closing of the vehicle door through the self-set door control password, further greatly improving the intelligence of the vehicle and the user experience.

Furthermore, based on the first embodiment and/or the second embodiment of the method for controlling opening and closing of the vehicle door of the present application, a third embodiment of the method for controlling opening and closing of the vehicle door of the present application is proposed.

In this embodiment, in order to further prevent rain from causing accidental touch operation in the capacitive sensing area, the vehicle further configures a protection electrode area around the capacitive sensing area. For example, as shown in FIG. 2, the vehicle is configured with protection electrode areas, i.e., protective areas, in front and behind the sensing area. In addition, the vehicle is also configured with corresponding algorithm strategies based on the protection electrode area to further reduce the probability of the vehicle door being opened or closed due to accidental touch.

Based on this, in this embodiment, the method for controlling opening and closing of the vehicle door of the present application may further include:
Step I, collecting a protection capacitance value around the capacitive sensing area through the protection electrode area, and detecting whether the protection capacitance value exceeds a preset protection capacitance threshold;
Step II, if the protection capacitance value exceeds the protection capacitance threshold, shielding the induction signal collected by the capacitive sensing area.

In this embodiment, in addition to collecting the touch sliding operation performed by the vehicle user through the above-mentioned capacitive sensing area, the vehicle also continuously detects the capacitance value of the peripheral position of the capacitive sensing area based on the protection electrode area to obtain the protection capacitance value. Then, the vehicle detects the protection capacitance value in combination with the pre-configured algorithm strategy, that is, detects whether the protection capacitance value exceeds the preset protection capacitance threshold. Therefore, if it is detected that the capacitance value collected based on the protection electrode area exceeds the protection capacitance threshold, the vehicle determines that the current capacitance value is caused by other conductive media such as rainwater. Therefore, even if the vehicle collects the induction signal of the trigger capacitor through the capacitive sensing area at this time, the vehicle will also believe that the capacitor trigger does not belong to the touch sliding operation performed by the vehicle user on the capacitive sensing area. Therefore, the vehicle directly shields the induction signal.

In addition, if the vehicle detects that the capacitance value collected based on the protection electrode area does not exceed the protection capacitance threshold, the vehicle can respond to the touch sliding operation collected simultaneously in the capacitive sensing area to control the opening or closing of the vehicle door according to the process described in the first embodiment and/or the second embodiment above.

It should be noted that, in a feasible embodiment, the above protection capacitance threshold can be specifically set to 140. It should be understood that based on different design requirements of actual applications, in different feasible embodiments, the vehicle can of course be configured with protection capacitance thresholds of other sizes, and the method for controlling opening and closing of the vehicle door of the present application is not limited to the specific size of the protection capacitance threshold.

In an embodiment of the present application, the method for controlling opening and closing of the vehicle door of the present application configures a protection electrode area of the vehicle at a peripheral position of the above-mentioned capacitive sensing area, and sets a corresponding algorithm strategy, so as to perform accidental touch judgment based on the size of the capacitance value collected by the protection electrode area, thereby further preventing conductive media such as rainwater from forming accidental touch operations in the capacitive sensing area, thereby further reducing the probability of the vehicle door being opened or closed due to accidental touch.

In addition, the present application also provides a device for controlling opening and closing of the vehicle door. The device for controlling opening and closing of the vehicle door of the present application is applied to a vehicle equipped with a capacitive sensing area, and the capacitive sensing area includes a plurality of capacitive sensing points.

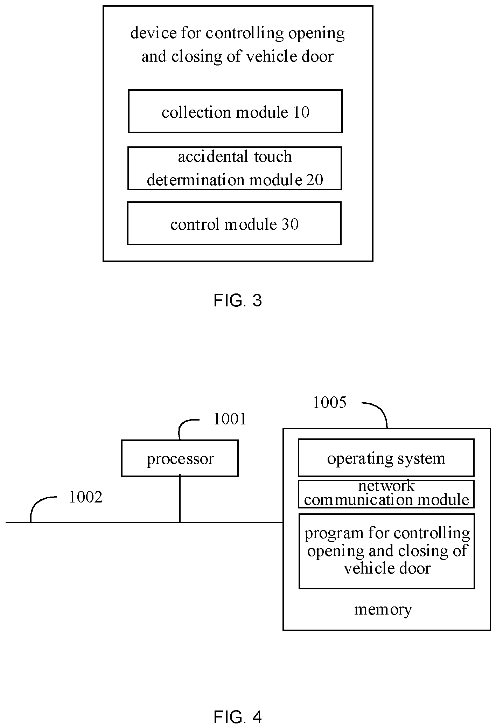

As shown in FIG. 3, the device for controlling opening and closing of the vehicle door of the present application includes:
A collection module 10, configured for collecting a touch sliding operation performed by a vehicle user through the capacitive sensing area;
A accidental touch determination module 20, configured to determine whether the touch sliding operation is an accidental touch operation according to the trigger state information of the touch sliding operation on the plurality of the capacitive sensing points;
A control module 30, configured to control the opening or closing of the vehicle door according to the triggering sequence of the touch sliding operation on the plurality of capacitive sensing points when it is determined that the touch sliding operation is not an accidental touch operation.

In an embodiment, the device for controlling opening and closing of the vehicle door of the present application further includes:
An information acquisition module, configured to obtain the touch dwell time of the touch sliding operation on a first sensing point among the multiple capacitive sensing points; the first sensing point is the first capacitive sensing point arranged corresponding to the opening and closing direction of the vehicle door among the multiple capacitive sensing points; obtaining the touch sliding speed of the touch sliding operation on two adjacent sensing points among the multiple capacitive sensing points; obtaining the touch sliding time for the touch sliding operation to complete the touch on all the multiple capacitive sensing points; and determining the touch dwell time, the touch sliding speed and the touch sliding time as trigger state information of the touch sliding operation on the multiple capacitive sensing points.

In an embodiment, the accidental touch determination module 20 includes:
An algorithm detection unit, configured to detect whether the touch dwell time is greater than a preset dwell time threshold, detect whether the touch sliding speed is greater than a preset speed threshold, and detect whether the touch sliding time belongs to a preset sliding completion time range;
An accidental touch determination unit, configured to determine that the touch sliding operation is not an accidental touch operation if the touch dwell time is greater than the dwell time threshold, the touch sliding speed is greater than the speed threshold, and the touch sliding time belongs to the sliding completion time range.

In an embodiment, the number of the plurality of capacitive sensing points is greater than or equal to three; the control module 30 includes:
A determination unit, configured to determine a triggering sequence of the touch sliding operation on at least three capacitive sensing points among the plurality of capacitive sensing points;
A control unit, configured for controlling the vehicle door to be opened if the triggering sequence corresponds to the direction in which the vehicle door is opened, or for controlling the vehicle door to be closed if the triggering sequence corresponds to the direction in which the vehicle door is closed.

In an embodiment, the control module 30 is also configured for obtaining the real-time opening and closing state of the vehicle door; controlling the opening or closing of the vehicle door according to the real-time opening and closing state and the correspondence between the triggering sequence and the opening and closing direction of the vehicle door; or, according to the real-time opening and closing state and the correspondence between the triggering sequence and the opening and closing direction of the vehicle door, outputting a preset opening and closing instruction prompt of the vehicle door to control the opening or closing of the vehicle door based on a confirmation operation of the opening and closing instruction prompt of the vehicle door.

In an embodiment, the device for controlling opening and closing of the vehicle door of the present application further includes:
A password configuration module, configured to collect the password configuration operation of the vehicle door performed by the vehicle user through the capacitive sensing area; and configure the triggering sequence of the vehicle password configuration operation of the vehicle door for the plurality of capacitive sensing points as a vehicle door control password;
The control module 30 of the device for controlling opening and closing of the vehicle door of the present application is also configured to control the opening or closing of the vehicle door when the triggering sequence of the touch sliding operation collected by the capacitive sensing area for multiple capacitive sensing points is consistent with the control password of the vehicle door.

In an embodiment, the vehicle is further configured with a protection electrode area, and the protection electrode area is configured at a peripheral position of the capacitive sensing area;
The accidental touch determination module 20 of the device for controlling opening and closing of the vehicle door of the present application is also configured to collect the protection capacitance value around the capacitive sensing area through the protection electrode area, and detect whether the protection capacitance value exceeds the preset protection capacitance threshold; and, if the protection capacitance value exceeds the protection capacitance threshold, the induction signal collected by the capacitive sensing area is shielded.

The specific implementation of the device for controlling opening and closing of the vehicle door of the present application is basically the same as the various embodiments of the method for controlling opening and closing of the vehicle door described above, and will not be described in detail here.

In addition, an embodiment of the present application also provides a vehicle as mentioned in any of the above embodiments.

Referring to FIG. 4, FIG. 4 is a schematic diagram of the device structure of the hardware operating environment involved in the vehicle mentioned in the embodiment of the present application. The vehicle mentioned in the embodiment of the present application is equipped with a capacitive sensing area, and the capacitive sensing area includes a plurality of capacitive sensing points.

As shown in FIG. 4, the vehicle may include: a processor 1001, such as a central processing unit (CPU), a memory 1005, and a communication bus 1002. The communication bus 1002 is configured to realize the connection and communication between the processor 1001 and the memory 1005. The memory 1005 may be a high-speed random access memory (RAM) or a stable memory (non-volatile memory), such as a disk memory. The memory 1005 may optionally be a storage device independent of the aforementioned processor 1001.

In an embodiment, the vehicle further includes a methanol range extender, a vehicle control unit (VCU), a battery management system (BMS), an engine management system (EMS) and a generator control unit (GCU). Among them, the vehicle control unit (VCU) communicates with the battery management system (BMS) and the like through an external public CAN, and communicates with the engine management system (EMS) and the generator control unit (GCU) through an internal CAN. In addition, the vehicle may also include a body control module (BCM), an electronic control unit (ECU) and a rectangular user interface, a network interface, a camera, an radio frequency (RF) circuit, a sensor, an audio circuit, a WiFi module, and the like. The rectangular user interface may include a display, an input submodule such as a keyboard, and the optional rectangular user interface may also include a standard wired interface and a wireless interface. The network interface may optionally include a standard wired interface and a wireless interface (such as a WI-FI interface). The vehicle is also connected to the remote service platform- telematics service provider (TSP) through a T-BOX for communication.

Those skilled in the art will understand that the structure shown in FIG. 4 does not constitute a limitation on the vehicle. Based on different design requirements of actual applications, in different feasible implementations, the vehicle may of course include more or fewer components than shown in the figure, or a combination of certain components, or a different arrangement of components.

As shown in FIG. 4, the memory 1005 as a storage medium may include an operating system, a network communication module, and a program for controlling opening and closing of the vehicle door. The operating system is a program for managing and controlling vehicle hardware and software resources, and supports the operation of the program for controlling opening and closing of the vehicle door and other software and/or programs. The network communication module is configured to realize the communication between the components inside the memory 1005, and the communication with other hardware and software in the device for controlling opening and closing of the vehicle door.

In the vehicle shown in FIG. 4, the processor 1001 is configured to execute the program for controlling opening and closing of the vehicle door stored in the memory 1005, and implement the steps of the method for controlling opening and closing of the vehicle door described in any of the above embodiments.

The specific implementation of the vehicle of the present application is basically the same as the above-mentioned embodiments of the method for controlling opening and closing of the vehicle door, and will not be repeated here.

In addition, an embodiment of the present application also provides a computer readable storage medium, and the computer readable storage medium stores one or more programs. The one or more programs can also be executed by one or more processors to implement the steps of any of the above-mentioned methods for controlling opening and closing of the vehicle door.

The specific implementation of the computer readable storage medium of the present application is basically the same as the above-mentioned embodiments of the method for controlling opening and closing of the vehicle door, and will not be repeated here.

In addition, the present application also provides a computer program product, including a computer program, which implements the steps of the above-mentioned method for controlling opening and closing of the vehicle door when executed by a processor.

The specific implementation of the computer program product of the present application is basically the same as the above-mentioned embodiments of the method for controlling opening and closing of the vehicle door, and will not be repeated here.

It should be noted that, in this article, the terms "include", "comprise" or any other variations thereof are intended to cover non-exclusive inclusion, so that a process, method, article or device including a series of elements includes not only those elements, but also other elements not explicitly listed, or also includes elements inherent to such process, method, article or device. In the absence of further restrictions, an element defined by the sentence "comprises a ..." does not exclude the existence of other identical elements in the process, method, article or device including the element.

The serial numbers of the embodiments of the present application are for description only and do not represent the advantages or disadvantages of the embodiments.

Through the description of the above implementation methods, those skilled in the art can clearly understand that the above-mentioned embodiment methods can be implemented by means of software plus a necessary general hardware platform, and of course by hardware, but in many cases the former is a better implementation method. Based on this understanding, the technical solution of the present application, or the part that contributes to the relevant technology, can be embodied in the form of a software product, which is stored in a storage medium (such as ROM/RAM, disk, CD), including a number of instructions for a terminal device (which can be a car computer, a smart phone, a computer, or a server, etc.) to execute the methods described in each embodiment of the present application.

The above are only some embodiments of the present application, and are not intended to limit the patent scope of the present application. All equivalent structures or equivalent process transformations made by using the description of the present application and the accompanying drawings, directly or indirectly used in other related technical fields, are all included in the protection scope of the present application in the same way.

## Claims

1. A method for controlling opening and closing of a vehicle door, wherein the method for controlling opening and closing of the vehicle door is applied to a vehicle equipped with a capacitive sensing area, and the capacitive sensing area comprises a plurality of capacitive sensing points;
**characterized in that**, the method for controlling opening and closing of the vehicle door comprises:
collecting a touch sliding operation performed by a vehicle user through the capacitive sensing area;
determining whether the touch sliding operation is an accidental touch operation according to trigger state information of the touch sliding operation on the plurality of capacitive sensing points; and
in response to that the touch sliding operation is not the accidental touch operation, controlling opening or closing the vehicle door according to a triggering sequence of the touch sliding operation for the plurality of capacitive sensing points.

2. The method for controlling opening and closing of the vehicle door according to claim 1, wherein before the determining whether the touch sliding operation is the accidental touch operation according to the trigger state information of the touch sliding operation on the plurality of capacitive sensing points, the method further comprises:
acquiring a touch dwell time of the touch sliding operation on a first sensing point among the plurality of capacitive sensing points, wherein the first sensing point is a first capacitive sensing point arranged in a direction corresponding to an opening and closing direction of the vehicle door among the plurality of capacitive sensing points;
acquiring a touch sliding speed of the touch sliding operation on two adjacent sensing points among the plurality of capacitive sensing points;
acquiring a touch sliding time for the touch sliding operation to complete touching the plurality of capacitive sensing points; and
determining the touch dwell time, the touch sliding speed and the touch sliding time as the trigger state information of the touch sliding operation for the plurality of capacitive sensing points.

3. The method for controlling opening and closing of the vehicle door according to claim 2, wherein the determining whether the touch sliding operation is the accidental touch operation according to the trigger state information of the touch sliding operation on the plurality of capacitive sensing points comprises:
detecting whether the touch dwell time is greater than a preset dwell time threshold, detecting whether the touch sliding speed is greater than a preset speed threshold, and detecting whether the touch sliding time belongs to a preset sliding completion time range; and
in response to the touch dwell time being greater than the dwell time threshold, the touch sliding speed being greater than the speed threshold, and the touch sliding time belonging to the sliding completion time range, determining that the touch sliding operation is not the accidental touch operation.

4. The method for controlling opening and closing of the vehicle door according to claim 1, wherein a number of the plurality of capacitive sensing points is greater than or equal to three;
the controlling opening or closing the vehicle door according to the triggering sequence of the touch sliding operation for the plurality of capacitive sensing points comprises:
determining a triggering sequence of the touch sliding operation on at least three capacitive sensing points among the plurality of capacitive sensing points; and
in response to that the triggering sequence corresponds to the opening direction of the vehicle door, controlling the vehicle door to be opened; or, in response to that the triggering sequence corresponds to the closing direction of the vehicle door, controlling the vehicle door to be closed.

5. The method for controlling opening and closing of the vehicle door according to claim 4, wherein after the determining the triggering sequence of the touch sliding operation on at least three capacitive sensing points among the plurality of capacitive sensing points, the method further comprises:
acquiring a real-time opening and closing state of the vehicle door;
controlling the vehicle door to be opened or closed according to the real-time opening and closing state and a corresponding relationship between the triggering sequence and the opening and closing direction of the vehicle door; or
according to the real-time opening and closing state and the corresponding relationship between the triggering sequence and the opening and closing direction of the vehicle door, outputting a preset opening and closing instruction prompt of the vehicle door to control the vehicle door to be opened or closed based on a confirmation operation of the opening and closing instruction prompt of the vehicle door.

6. The method for controlling opening and closing of the vehicle door according to claim 1, wherein the method further comprises:
collecting a password configuration operation of the vehicle door performed by a vehicle user through the capacitive sensing area;
configuring the triggering sequence of the password configuration operation of the vehicle door for the plurality of capacitive sensing points as a control password of the vehicle door; and
in response to that the triggering sequence of the touch sliding operation collected by the capacitive sensing area for the plurality of capacitive sensing points is consistent with the control password of the vehicle door, controlling the vehicle door to be opened or closed.

7. The method for controlling opening and closing of the vehicle door according to any one of claims 1 to 6, wherein the vehicle is further provided with a protection electrode area, and the protection electrode area is provided at a peripheral position of the capacitive sensing area; the method further comprises:
collecting a protection capacitance value around the capacitive sensing area through the protection electrode area, and detecting whether the protection capacitance value exceeds a preset protection capacitance threshold; and
in response to that the protection capacitance value exceeds the protection capacitance threshold, shielding a induction signal collected by the capacitive sensing area.

8. A device for controlling opening and closing of a vehicle door, wherein the device for controlling opening and closing of the vehicle door is applied to a vehicle equipped with a capacitive sensing area, and the capacitive sensing area comprises a plurality of capacitive sensing points;
**characterized in that**, the device for controlling opening and closing of the vehicle door comprises:
a collection module, configured for collecting a touch sliding operation performed by a vehicle user through the capacitive sensing area;
an accidental touch determination module, configured to determine whether the touch sliding operation is an accidental touch operation according to trigger state information of the touch sliding operation on the plurality of capacitive sensing points; and
a control module, configured to control opening or closing of the vehicle door according to a triggering sequence of the touch sliding operation for the plurality of the capacitive sensing points in response to that the touch sliding operation is not the accidental touch operation.

9. A vehicle, **characterized by** comprising:
a memory;
a processor; and
a program stored in the memory for implementing a method for controlling opening and closing of a vehicle door;
wherein the memory is configured to store the program for implementing the method for controlling opening and closing of the vehicle door; and
the processor is configured to execute the program for implementing the method for controlling opening and closing of the vehicle door, so as to implement the steps of the method for controlling opening and closing of the vehicle door according to any one of claims 1 to 7.

10. A computer readable storage medium, **characterized in that** a program for implementing a method for controlling opening and closing of a vehicle door is stored on the computer readable storage medium, and the program for implementing the method for controlling opening and closing of the vehicle door is executed by a processor to implement the steps of the method for controlling opening and closing of the vehicle door according to any one of claims 1 to 7.
